# EUROPEAN PATENT APPLICATION

(11) **EP 2 136 611 A1**
(43) Date of publication of application: **23.12.2009**
(21) Application number: 09162785.1
(22) Date of filing: 16.06.2009
(51) Int. Cl.: H05K 5/02, H05K 7/14, H01J 17/49

(54) **Plasma display module, display device including the same, and associated methods**

(30) Priority: 18.06.2008 KR 20080057485
(71) Applicant: Samsung SDI Co., Ltd., Gyeonggi-do (KR)
(72) Inventor: Kim, Won-Sung, Gyeonggi-do (KR); Kwon, Joong-Yeol, Gyeonggi-do (KR); Kim, Jae-Gyoung, Gyeonggi-do (KR); Bae, Sung-Won, Gyeonggi-do (KR); Lee, Won-Hee, Gyeonggi-do (KR); Ha, Dong-Jin, Gyeonggi-do (KR)
(74) Representative: Perkins, Dawn Elizabeth

(57) **Abstract**

A plasma display module, a display device, and associated methods, the plasma display module including a plasma display panel, and a chassis base including a main body, a first side, a second side, and at least one protrusion, wherein the plasma display panel is attached to the first side of the chassis base, the at least one protrusion extends from the second side of the chassis base, and the chassis base and the at least one protrusion are integrally formed.

## Description

Embodiments relate to a plasma display module, a display device including the same, and associated methods.

In general, a plasma display panel (PDP) includes two substrates each including a plurality of electrodes, wherein a discharge gas is filled between the substrates and the substrates are sealed. When a discharge voltage is applied to the electrodes, a plasma discharge may occur in a discharge space defined by the substrates.

In PDPs, ultraviolet rays generated due to the plasma discharge excite phosphor layers formed into a predetermined pattern, thereby displaying an image. Unlike conventional cathode-ray tubes (CRTs), PDPs may be manufactured to be lightweight, planar, and thin. Due to these advantages, PDPs are receiving much attention.

Conventionally, in a plasma display module, a PDP may be mounted on one side of a chassis base and driving boards may be mounted on another side of the chassis base. In some cases, the driving boards may be spaced apart from the surface of the chassis base by a predetermined distance. In other cases, a plurality of driving boards may be mounted on the chassis base and may be spaced apart from each other at intervals on the chassis base.

To stably support the PDP and the driving boards, the chassis base should have sufficient rigidity. To this end, the chassis base may be formed to be relatively thick. However, there is a limit on increasing the thickness of the chassis base, and thus other methods of maintaining sufficient rigidity have been developed. For example, reinforcement members may be attached to the chassis base. Since rigidity of the chassis base may be reinforced by attaching a reinforcement member thereto, the chassis base may rigidly support the PDP and the driving boards even when the chassis base is relatively thin.

However, it may be difficult to attach the reinforcement member to the chassis base, and thus, manufacturing costs and time may be increased.

In addition, conventionally, when various components, e.g., the driving board, are mounted on the chassis base, a fixing member, e.g., a boss, may need to be mounted on a surface of the chassis base so that the driving board may be spaced apart from the chassis base by a predetermined distance. However, a PDP may include a large number of driving boards for its operation and accordingly, a large number of bosses may be needed. Such requirement may complicate the process of manufacturing the chassis base.

Embodiments are therefore directed to a plasma display module, a display device including the same, and associated methods, which substantially overcome one or more of the problems due to the limitations and disadvantages of the related art.

It is therefore a feature of an embodiment to provide a display device including a chassis base having sufficient rigidity and a small thickness.

It is therefore also feature of an embodiment to provide a display device including a chassis base having sufficient rigidity without a reinforcement member

It is therefore another feature of an embodiment to provide a display device having reduced production costs.

It is therefore yet another feature of an embodiment to provide a display device including a chassis base that allows a component such as a driving board, to be easily mounted thereon without any attachment member.

At least one of the above and other features and advantages may be realized by providing a plasma display module, including a plasma display panel, and a chassis base including a main body, a first side, a second side, and at least one protrusion, wherein the plasma display panel is attached to the first side of the chassis base, the at least one protrusion extends from the second side of the chassis base, and the chassis base and the at least one protrusion are integrally formed.

The thickness of the protrusion may be substantially the same as the thickness of the main body of the chassis base.

The main body may have a surface, and the protrusion may extend along the surface of the main body of the chassis base.

The chassis base may include a plurality of protrusions and the plurality of protrusions may be connected to each other.

The plasma display module may further include at least one driving board connected to the at least one protrusion and to the second side of the chassis base.

The plasma display module may further include a coupling member and at least one boss in the at least one protrusion, wherein the driving board may be attached to the chassis base by the coupling member that is coupled to the boss.

The chassis base may include a drawing quality material.

The drawing quality material may include about 0.12 wt.% or less of carbon.

The drawing quality material may include about 0.5 wt.% or less of manganese (Mn), about 0.04 wt.% or less of phosphorus (P), and about 0.04 wt.% or less of sulfur (S).

The yield strength of the chassis base may be about 240 N/mm2 or less.

The tensile strength of the chassis base may be about 270 N/mm2 or more.

At least one of the above and other features and advantages may also be realized by providing a display device, including a housing, a plasma display panel, and a chassis base including a main body, a first side, a second side, and at least one protrusion, wherein the plasma display panel is attached to the first side of the chassis base, the at least one protrusion extends from the second side of the chassis base, and the chassis base and the at least one protrusion are integrally formed.

The plasma display panel may include a region for displaying an image, and the housing may include a top cabinet disposed on a top side of the chassis base such that the region for displaying an image of the plasma display panel is disposed at the center of the top cabinet, and a bottom cabinet disposed on the opposite side of the chassis base to the top side, and coupled to the top cabinet.

At least one of the above and other features and advantages may also be realized by providing a method of manufacturing a display device, including providing a housing, providing a plasma display panel, and forming a chassis base, the plasma display panel and chassis base being for disposition in the housing, the chassis base including a main body, a first side, a second side, and at least one protrusion, wherein the plasma display panel is attached to the first side of the chassis base, the at least one protrusion extends from the second side of the chassis base, and the chassis base and the at least one protrusion are integrally formed.

The protrusion and the chassis base may be formed by pressing the chassis base.

The chassis base and the at least one protrusion may be formed simultaneously.

The above and other features and advantages will become more apparent to those of ordinary skill in the art by describing in detail exemplary embodiments thereof with reference to the attached drawings, in which:
FIG. 1 illustrates an exploded perspective view of a plasma display module according to an embodiment;
FIG. 2 illustrates a schematic view of a chassis base of the plasma display module of FIG. 1, according to an embodiment;
FIG. 3 illustrates a sectional view taken along a line III-III of FIG. 1, according to an embodiment; and
FIG. 4 illustrates an exploded perspective view of a display device including the plasma display module of FIG. 1, according to an embodiment.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the invention to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

As used herein, the expressions "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C" and "A, B, and/or C" includes the following meanings: A alone; B alone; C alone; both A and B together; both A and C together; both B and C together; and all three of A, B, and C together. Further, these expressions are open-ended, unless expressly designated to the contrary by their combination with the term "consisting of." For example, the expression "at least one of A, B, and C" may also include an nth member, where n is greater than 3, whereas the expression "at least one selected from the group consisting of A, B, and C" does not.

As used herein, the expression "or" is not an "exclusive or" unless it is used in conjunction with the term "either." For example, the expression "A, B, or C" includes A alone; B alone; C alone; both A and B together; both A and C together; both B and C together; and all three of A, B, and C together, whereas the expression "either A, B, or C" means one of A alone, B alone, and C alone, and does not mean any of both A and B together; both A and C together; both B and C together; and all three of A, B, and C together.

As used herein, the terms "a" and "an" are open terms that may be used in conjunction with singular items or with plural items. For example, the term "a metal" may represent a single compound, e.g., aluminum, or multiple compounds in combination, e.g., aluminum mixed with iron.

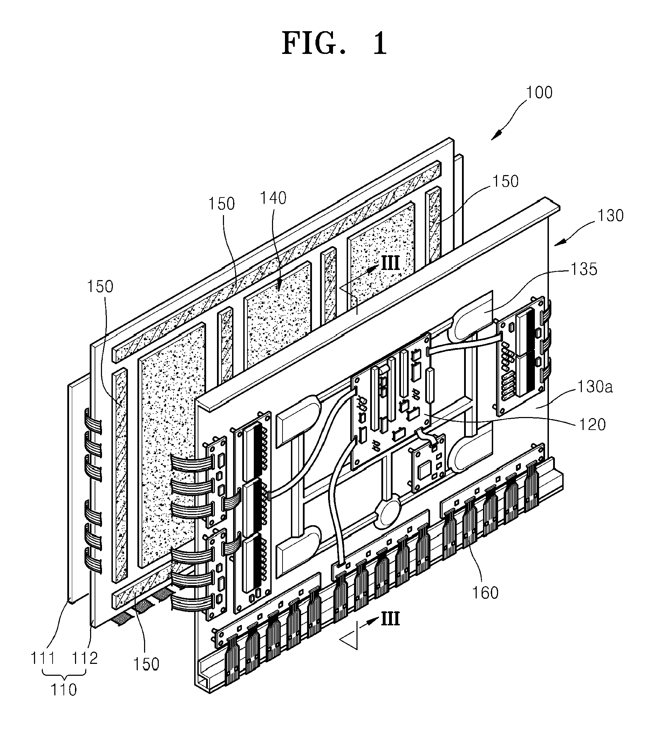

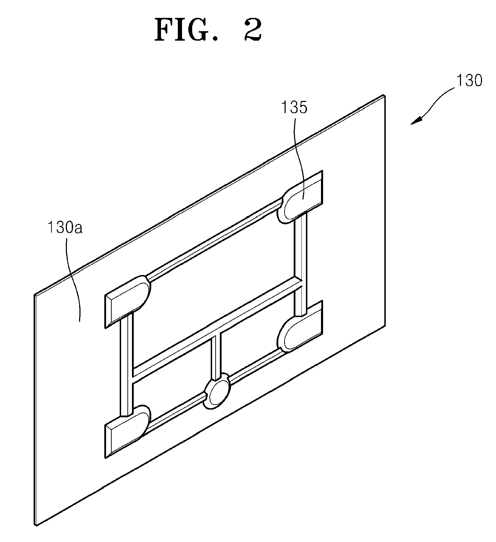

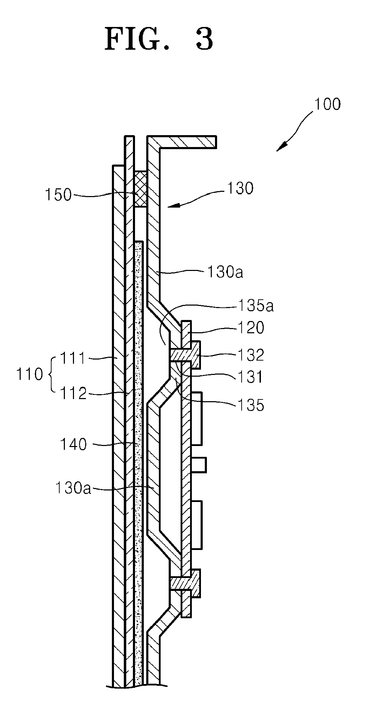

FIG. 1 illustrates an exploded perspective view of a plasma display module 100 according to an embodiment. FIG. 2 illustrates a schematic view of a chassis base 130 having a protrusion 135 of the plasma display module 100 of FIG. 1. FIG. 3 illustrates a sectional view taken along a line III-III of FIG. 1.

Referring to FIGS. 1-3, the plasma display module 100 according to an embodiment may include a PDP 110, a driving board 120, and the chassis base 130.

The PDP 110 may display an image. The PDP 110 may be mounted on a side of the chassis base 130, and may be supported by the chassis base 130. At least one fixed member may be mounted on another side of the chassis base 130. The fixed member may include the driving board 120.

The side of the chassis base 130 on which the PDP 110 is mounted will be referred to as a top surface of the chassis base 130, and the opposite side of the chassis base 130 will be referred to as a bottom surface of the chassis base 130.

To mount at least one fixed member, the protrusion 135 may be formed on the bottom surface of the chassis base 130. Specifically, the protrusion 135 formed on the bottom surface of the chassis base 130 may be an integral part of the chassis base 130, and may protrude from the chassis base 130.

The protrusion 135 may have a thickness substantially the same as the thickness of the chassis base 130.

In addition, the protrusion 135 may extend along a surface of a main body 130a of the chassis base 130. In some cases, a plurality of protrusions 135 may be formed, and in such a case, the protrusions 135 may extend along the surface of the main body 130a of the chassis base 130 and be connected to each other. Due to the shape of the protrusion 135, rigidity of the chassis base 130 may be significantly increased.

That is, referring to FIGS. 2 and 3, the protrusion 135 may extend along the surface of the main body 130a of the chassis base 130, and may have a thickness substantially identical to that of the main body 130a.

The chassis base 130 and the protrusion 135 may be formed as one body forming structure. So, the chassis base 130 and the protrusion 135 may be formed as one body simultaneously, i.e., in a single step. Accordingly, rigidity of the chassis base 130 may be improved, the manufacturing costs may be reduced, and assembly characteristics may be improved.

Meanwhile, the protrusion 135 may be formed by pressing the chassis base 130 and thus, the protrusion 135 may be integrally formed as one body with the chassis base 130, and may be substantially uniform.

A portion of the chassis base 130 that is to be formed into the protrusion 135 may be bent according to the shape of the protrusion 135. When the portion is bent, a space 135a may be formed corresponding to the protrusion 135.

A nut may be located in the space 135a of the protrusion 135. The nut may be used for screw-bonding with a connecting member, e.g., a bolt, when a fixed member, e.g., the driving board 120, is attached to the chassis base 130. Accordingly, due to the protrusion 135, the fixed member, e.g., the driving board 120, may be easily assembled with the chassis base 130.

Since the fixed member may be fixed through the protrusion 135, a bracket may not be needed. That is, the protrusion itself 135 may function as a bracket, which has been conventionally used to fix a fixed member, e.g., a driving board. Therefore, the assembling operation may be simplified and easily performed.

In addition, since the space 135a of the protrusion 135 may include a space for assembling a fixed member, a boss may not be needed. In an embodiment, a through-hole 131 for assembling a fixed member may be formed in the protrusion 135 and a screw thread, which may be used for screw-bonding with a connecting member, may be formed in the through-hole.

The PDP 110 for displaying an image may include a first substrate 111 and a second substrate 112. The first substrate 111 may face the second substrate 112 and may be spaced apart from the second substrate 112 by a predetermined distance.

A discharge electrode, a phosphor layer, a discharge gas, etc. may be arranged between the first substrate 111 and the second substrate 112. The discharge electrode may include X and/or Y electrodes extending in a first direction and crossing an address electrode extending in a second direction.

Circuit devices may be arranged on the driving board 120 to form a circuit. The driving board 120 may be connected to the PDP 110 through a flexible cable 160. The driving board 120 may be attached to the chassis base 130.

A bolt 132 may be used to fix the driving board 120 on the chassis base 130. For the bolt 132, a female screw may be formed in the through-hole 131 in the protrusion 135. The through-hole 131 may be coupled to the bolt 132 so that the driving board 120 may be attached to the chassis base 130. As described above, the protrusion 135 may function as a boss that is coupled to a connecting member. However, the structure of the protrusion 135 is not limited thereto. In another embodiment, a boss may be further formed on the protrusion 135 of the chassis base 130.

In an embodiment, the connecting member may be the bolt 132. The bolt 132 may fix the driving board 120 on the chassis base 130 so that the driving board 120 surface-contacts the protrusion 135. In this regard, due to the protrusion 135, the driving board 120 may be spaced apart from the chassis base 130 by a predetermined distance.

That is, the driving board 120 may be located on the protrusion 135 and may be attached to the chassis base 130 by coupling the protrusion 135 to the bolt 132 through a through-hole in the driving board 120. To this end, a female nut may be disposed under the protrusion 135.

In the embodiment illustrated in FIG. 1, protrusions 135 may correspond to each of the four corners of a tetragonal-shaped driving board 120. The protrusions 135 may be connected to each other and integrally formed as one body.

To rigidly and stably support the PDP 110 and the driving board 120, the chassis base 130 may need to have sufficient rigidity. The protrusions 135 integrally formed with the chassis base 130 may reinforce rigidity of the chassis base 130 so that the chassis base 130 may have sufficient rigidity.

However, recently, displays are manufactured in large sizes but with small thicknesses. Due to this recent trend, a conventional method in which metal used to form a chassis base is pressed, may not be suitable for forming the chassis base 130 of an embodiment. That is, if a material that is suitable for pressing is used to form the protrusion 135, the chassis base 130 may not have sufficient rigidity. On the other hand, if a material having high rigidity is used, it may be difficult to press the chassis base 130 to form the protrusion 135.

To resolve these problems, an embodiment uses a drawing quality (DQ) material having a controlled amount of carbon. This DQ material may be suitable for the pressing and after the pressing. This DQ material may have sufficient rigidity, which may remain constant, in order to form the chassis base 130 that is integrally formed with the protrusion 135. When the DQ material is used, the protrusion 135 may be easily formed as one body with the chassis base 130 by, e.g., pressing.

The DQ material may be planarized by pressing. The DQ material may be, e.g., a cold rolled steel sheet that has a predetermined level of processability without deep drawing. The DQ material may include, e.g., a group of extra low carbon steel sheets. Specifically, the DQ material may include, e.g., deep-drawing rimmed steel or extra deep-drawing aluminum killed steel. Since the DQ material may be produced using a specific pressing process, the DQ material may withstand excess pressing, drawing, and forming operations. The DQ material may fulfill the criteria of KS D 3512 SPCD, a KS standard.

To satisfy various conditions required, the material for the chassis base 130 may include about 0.12 wt.% or less of carbon (C). The material for the chassis base 130 may further include about 0.5 wt.% or less of manganese (Mn), about 0.04 wt.% or less of phosphor (P), and about 0.04 wt.% or less of sulfur (S). The yield strength of the material for the chassis base 130 may be about 240 N/mm2 or less. The tensile strength of the material for the chassis base 130 may be about 270 N/mm2 or more.

The chassis base 130 used according to an embodiment may also be formed of other materials. For example, the chassis base 130 may be formed of, e.g., conductive iron or aluminum material.

Among various materials, however, in consideration of the weight of the plasma display module 100 and processability for forming one body, the DQ material that is lightweight, has high rigidity, and contains a controlled amount of carbon may be most suitable for forming the chassis base 130.

The PDP 110 may be coupled to the chassis base 130 by an adhesive layer 150. The adhesive layer 150 may be attached to the second substrate 112. The adhesive layer 150 may include a double-sided adhesive material, e.g., a double-sided tape.

The PDP 110 may be electrically connected to the driving board 120 through the flexible cable 160, e.g., a bendable signal transfer member.

The flexible cable 160 may be, e.g., a flexible printed cable (FPC) or a tape carrier package (TCP). The flexible cable 160 may cross the top surface of the chassis base 130 and may be connected to the address electrode and Y and/or X electrodes of the PDP 100.

The driving board 120 mounted on the bottom surface of the chassis base 130 may include a power board, a logic board, an X driving board, a Y driving board, and an address buffer board. Accordingly, the chassis base 130 may be divided into portions corresponding to those boards. That is, the chassis base 130 may include a power source board portion, a logic board portion, an X driving board portion, a Y driving board portion, and an address buffer board portion.

The power source board portion and the logic board portion may respectively include central upper and central lower portions of the chassis base 130. The X driving board portion may include a right portion of the chassis base 130. The Y driving board portion may include a left portion of the chassis base 130. The address buffer board portion may be positioned lower than the logic board portion, the X driving board portion, and the Y driving board portion, and extend along the entire length of the chassis base 130.

Meanwhile, a thermal sheet 140 may be interposed between the PDP 110 and the chassis base 130. The thermal sheet 140 may include a material, e.g., graphite, that has excellent thermal conductivity. A top surface of the thermal sheet 140 may contact the PDP 110.

In an embodiment, the thermal sheet 140 may include graphite. However, the material for forming the thermal sheet 140 is not limited thereto. That is, a thermal sheet according to an embodiment may include any suitable material that has excellent thermal conductivity. A bottom surface of the thermal sheet 140 may include a groove having, e.g., a rectangular, corrugated cross-section.

In an embodiment, the groove may have various shapes. That is, the shape of the groove of the thermal sheet according to an embodiment is not limited. In this regard, the groove of the thermal sheet according to an embodiment have any suitable shape that increases a surface area of the bottom surface of the thermal sheet 140 and increases a heat transfer rate.

In an embodiment, the groove may be uniformly formed on the entire area of the thermal sheet 140. However, the position of the groove according to an embodiment is not limited thereto. That is, a groove according to an embodiment may be locally formed in the thermal sheet 140 and, in this case, the groove may be formed in a portion of the thermal sheet 140 corresponding to an area of the PDP 110 where a great amount of heat is generated.

Meanwhile, in an embodiment, the bottom surface of the thermal sheet 140 may be spaced apart from the top surface of the chassis base 130 by a predetermined distance. However, the positional relationship between the thermal sheet 140 and the chassis base 130 is not limited thereto. In this regard, at least one part of the thermal sheet 140 according to an embodiment in which a groove is not formed may contact the chassis base 130.

As described above, the plasma display module 100 according to an embodiment may have high heat transfer efficiency by forming a groove in the thermal sheet 140 to increase a proportion of a portion of the bottom surface of the thermal sheet 140 through which heat may be transferred. When the groove is formed in the bottom surface of the thermal sheet 140 and the heat transfer portion of the bottom surface is increased, a great amount of heat generated from the PDP 110 may be quickly dissipated.

According to an embodiment, the chassis base 130 and the protrusion 135 may be integrally formed as one body. Therefore, rigidity of the chassis base 130 may be improved, the manufacturing costs may be reduced, and assembly characteristics may be improved.

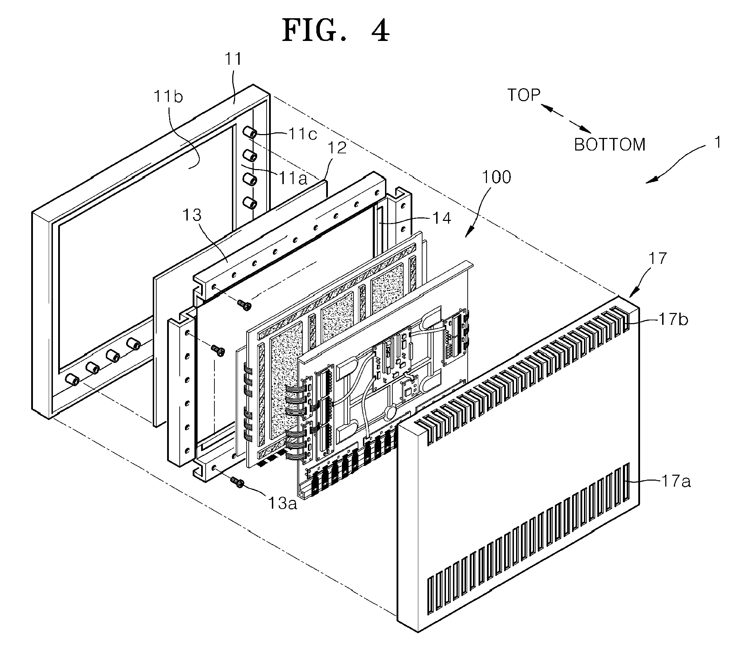

FIG. 4 illustrates an exploded, perspective view of a display device 1 including the plasma display module 100 of FIG. 1, according to an embodiment.

Referring to FIG. 4, the display device 1 according to an embodiment may include the plasma display module 100 described with reference to FIGS. 1-3. The plasma display device 1 may include a top cabinet 11, an electromagnetic-wave shielding filter 12, a filter holder 13, the PDP 110, the chassis base 130, the driving board 120, and a bottom cabinet 17.

The top cabinet 11 may include a window 11b at the center thereof. The top cabinet 11 may be coupled to the bottom cabinet 17. The plasma display module 100 described with reference to FIGS. 1-3 may be protected by being positioned between the top cabinet 11 and the bottom cabinet 17.

The electromagnetic-wave shielding filter 12 may be disposed behind the top cabinet 11 and cover the window 11b. The filter holder 13 may fix the electromagnetic-wave shielding filter 12 on a circumferential portion 11a of the top cabinet 11.

The PDP 110 may display an image, and may be disposed behind the filter holder 13. The chassis base 130 may support the PDP 110. The driving board 120 may drive the PDP 110 and may be mounted on the bottom surface of the chassis base 130.

The region of the PDP 110 displaying an image may be disposed at a window 11b.

The bottom cabinet 17 may be disposed behind the driving boards 120, and may be coupled to the top cabinet 11 so that the plasma display module 100 may be protected by being interposed between the bottom cabinet 17 and the top cabinet 11.

The electromagnetic-wave shielding filter 12 may contact a bottom surface of the top cabinet 11 by the filter holder 13 that is fixed by coupling of a screw accepting portion 11c and a screw 13a. The plasma display panel 110 may contact a sponge 14 attached to a bottom surface of the filter holder 13. The driving board 120 driving the PDP 110 may be connected to the PDP 110 through the cable 160, e.g., a FPC.

The bottom surface of the PDP 110 may be attached to the chassis base 130 through a heat dissipating sheet 140 having excellent thermal conductivity. Therefore, heat generated from the PDP 110 may be easily dissipated to the outside.

In addition, the chassis base 130 may have an opening in either a portion on which the driving board 120 is mounted or, when there are two or more driving boards 120, a portion between the driving boards 120. Therefore, noise may be prevented from being transmitted to the driving board 120 through the chassis base 130, or between the driving boards 120 through the chassis base 130.

According to an embodiment, the protrusion 135 and the chassis base 130 may be integrally formed as one body. Therefore, rigidity of the chassis base 130 may be increased, the manufacturing costs may be reduced, and assembly characteristics may be improved.

In the plasma display module and the display device including the same, according to the embodiments, a chassis base and a protrusion may be integrally formed as one body and thus sufficient rigidity may be secured. Therefore, the chassis base may stably support components, e.g., a plasma display panel and a driving board.

In addition, for the plasma display module and the display device including the same according to the embodiments, a reinforcement member for reinforcing rigidity of the chassis base may not be needed, and the chassis base may be integrally formed as one body together with a protrusion using a simple operation, e.g., a pressing operation.

Furthermore, since the chassis base and the protrusion may be integrally formed as one body, components, e.g., a driving board, may be attached to the chassis base without a bracket or a boss. Therefore, assembly characteristics may be improved.

Exemplary embodiments have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. A plasma display module, comprising:
a plasma display panel (110); and
a chassis base (130) including a main body (130a), a first side, a second side, and at least one protrusion (135), wherein the plasma display panel (110) is attached to the first side of the chassis base (130), the at least one protrusion (135) extends from the second side of the chassis base (130), and the chassis base (130) and the at least one protrusion (135) are integrally formed.

2. The plasma display module as claimed in claim 1, wherein the main body (130a) and the protrusion (135) are formed from a material having a substantially uniform thickness.

3. The plasma display module as claimed in claim 1 or 2, wherein the chassis base (130) includes a plurality of protrusions (135) and the plurality of protrusions (135) are connected to each other.

4. The plasma display module as claimed in any one of the preceding claims, further comprising at least one driving board (120) mounted on the second side of the chassis base (130) connected to the at least one protrusion (135).

5. The plasma display module as claimed in claim 4, further comprising a coupling member (132), wherein the driving board (120) is attached to the chassis base (130) by the coupling member (132).

6. The plasma display module as claimed in any one of the preceding claims, wherein the chassis base (130) comprises a drawing quality material.

7. The plasma display module as claimed in claim 6, wherein the drawing quality material includes about 0.12 wt.% or less of carbon.

8. The plasma display module as claimed in claim 6 or 7, wherein the drawing quality material includes about 0.5 wt.% or less of manganese (Mn), about 0.04 wt.% or less of phosphorus (P), and about 0.04 wt.% or less of sulfur (S).

9. The plasma display module as claimed in any one of claims 6 to 8, wherein a yield strength of the chassis base is about 240 N/mm² or less.

10. The plasma display module as claimed in any one of claims 6 to 9, wherein a tensile strength of the chassis base is about 270 N/mm² or more.

11. A display device, comprising:
a housing; and
a plasma display module (100) according to any one of the preceding claims.

12. A method of manufacturing a chassis base (130) for supporting a plasma display panel (110) in a plasma display device, comprising:
providing a drawing quality sheet material; and
pressing the sheet material to form the chassis base (130) having at least one protrusion on one side of the chassis base (130).

13. The method as claimed in claim 12, wherein the drawing quality material is cold rolled steel sheet having 0.12 wt % or less of carbon.

14. The method as claimed in claim 12 or 13, wherein the drawing quality material includes about 0.5 wt.% or less of manganese (Mn), about 0.04 wt.% or less of phosphorus (P), and about 0.04 wt.% or less of sulfur (S).

15. A method of manufacturing a plasma display module (100) comprising:
manufacturing a chassis base (13) according to the method of any one of claims 12 to 14;
mounting at least one driving board (120) on the side of the chassis base (130) from which the protrusion (135) projects by connecting the driving board (120) to the protrusion (135) by a coupling member (132); and
attaching a plasma display panel (110) to the other side of the chassis base (130).
